# EUROPEAN PATENT APPLICATION

(11) **EP 2 325 876 A2**
(43) Date of publication of application: **25.05.2011**
(21) Application number: 10192039.5
(22) Date of filing: 22.11.2010
(51) Int. Cl.: H01L 21/56, H01L 23/29

(54) **Epoxy resin formulations for underfill applications**

(30) Priority: 23.11.2009 US 263459 P
(71) Applicant: DOW Global Technologies, Midland, MI 48674 (US)
(72) Inventor: Wilson, Mark B, Clute, TX 77531 (US); Potisek, Stephanie L, Pearland, TX 77584 (US)
(74) Representative: Buckley, Guy Julian

(57) **Abstract**

Disclosed is a low viscosity, low to no chloride containing epoxy resin formulation including a divinylbenzene dioxide as a component in the formulation; wherein the formulation is useful for the manufacture of capillary underfill compositions.

## Description

The present invention relates to epoxy resin formulations useful for the manufacture of semiconductor electronic packaging materials, and more specifically, capillary underfill encapsulants.

Epoxy resins are commonly used in the electronics industry for making semiconductor packaging materials. Current epoxy resin formulations used in semiconductor packaging materials include, for example, high purity diglycidyl ether of bisphenol F or diglycidyl ether of bisphenol A along with high performance or multifunctional resins such as the digylcidyl ether of naphthalene diol or the triepoxide of para-aminophenol. The known epoxy resins suffer from balancing key attributes required for acceptable processability and downstream reliability. These attributes include viscosity, total chloride content, filler loading (for coefficient of thermal expansion (CTE) and modulus modification), adhesion, flux compatibility, toughness, dispense-ability, flow, and package level reliability performance including preconditioning, temperature cycle or shock, highly accelerated stress testing (HAST).

Conventional underfill formulation approaches incorporate high purity bisphenol F or bisphenol A epoxy resins along with high performance or multifunctional epoxy resins. The inclusion of the high performance resins tends to increase the viscosity of the resultant blend negatively impacting the processability of the formulation, limiting both the amount and size of the particulate filler that can be incorporated into the formulation. Trends in electronic packaging designs toward smaller, stacked and high pitch configurations increase the demands on electronic packaging materials requiring better thermomechanical and processing performance. For example, new underfill materials for electronic packaging need to have a lower CTE for resistance to thermal fatigue, while new thermal interface materials (TIMs) need to be more thermally-conductive for cooling a heat-generating source while maintaining low viscosity with increased filler loadings.

Many electronic packaging materials are highly filled materials. The properties of the filled materials largely depend on the type of filler used and the level of filler loading (or amount of filler in the materials). In general, increasing the filler loading level usually decreases the CTE while the modulus and thermal conductivity increase. Unfortunately, the viscosity of the material also increases with an increase in filler loading. During the application of these filled materials for electronic packaging, underfill encapsulants are required to have a low viscosity (for example, less than 0.7 Pa-s at the dispense temperature) for adequate processing and complete, void-free, underfilling of a die. Thus, relatively higher application temperatures are required to ensure adequate flow of conventional, highly-filled underfill formulations.

Typical capillary underfill formulations incorporate the digycidyl ethers of bisphenol A or bisphenol F along with modifiers to improve the thermomechanical properties, such as the glass transition temperature (Tg), of the cured system. For example, U.S. Patent No. 7,482,201 teaches the use of Epon® 862 and Epon® 828 (Hexion Specialty Chemicals), along with Araldite® MY-0510 (Huntsman Advanced Materials) for nano-filled underfill encapsulants. The Epon® 862 is a bisphenol F based epoxy resin. The Epon® 828 is a bisphenol A based epoxy resin, and the Araldite® MY-0510 is 4-(oxiran-2-ylmethoxy)-N,N-bis(oxiran-2-ylmethyl)aniline. U.S. Patent No. 7,279,223 discloses a number of aliphatic, cycloaliphatic, and aromatic epoxy resins. The use of conventional cycloaliphatic resins with low to no chloride content is limited by suitable curing chemistries which are primarily anhydride or Lewis acid hardeners. U.S. Patent No. 7,351,784 teaches the use of cycloaliphatic amines and carbenes for capillary and no flow underfill formulations. Specific aliphatic amine structures cited are 4-(2-aminopropan-2-yl)-l-methylcyclohexanamine and 4,4'-methylenebis(2-methylcyclohexanamine).

The before mentioned epoxy resins are manufactured utilizing epichlorohydrin which is reacted with the phenolic hydroxyl group, or in the case of an aromatic amine, with the amino group resulting in the epoxy resin. During the coupling process, incomplete ring closure can occur resulting in bound or hydrolyzable chloride.

The hydrolyzable chloride content of the resin can have negative impact on the performance of the device or component during reliability testing, especially high humidity and high temperature testing such as pressure cooker exposure (PCT) 121 °C / 15 psi steam. During exposure to high humidity testing, the hydrolyzable chloride can be extracted from the cured polymer and form highly acidic species causing corrosion within the device. Therefore, base resins that are useful in underfill applications and that do not use epichlorohydrin or other halogenated reactants to manufacture the epoxy resin are highly desirable.

There is a need for an electronic packaging material for capillary underfill that is a highly filled material with low viscosity and improved thermomechanical properties (CTE, Tg, modulus, and in some cases, thermal conductivity) as compared to conventional underfill materials. Such material should preferably have improved processability and downstream package reliability. Further, such materials should have a total chloride content of less than 100 ppm, and more preferably less than 5 ppm.

Ultimately, what is needed in the electronics industry is to develop formulated materials with low CTE (for example, less than 30 ppm/°C), high thermal conductivity (for example, greater than 0.7 W/mK), moderate modulus (for example, from 3 GPa to 15 GPa) and proper flow in the case of underfill encapsulants (15 - 100 sec. across 15 mm in a 20 µm gap), the ability to tune the Tg after cure for example, from 25 - 300 °C) for a specific application, all while maintaining acceptable rheology performance of less than 10 Pa-s at a temperature of 25 °C and less than 1.0 Pa-s at a temperature range from 30 °C to 100 °C.

Therefore, one objective of the present invention is to develop epoxy underfill compositions with low viscosity even when they contain a relatively high level of filler, and which can be cured with a wide range of epoxy curing agents. It is preferred that such underfill compositions have very low to no total chloride content.

One embodiment of the present invention is directed to an epoxy resin formulation for the manufacture of electronic packaging materials such as semiconductor packaging materials, more specifically capillary underfill encapsulants comprising a divinylarene dioxide, such as 1,4-di(oxiran-2-yl)benzene / 1,3-di(oxiran-2-yl)benzene (collectively divinylbenzene dioxide or DVBDO), as one component in the formulation. The utilization of DVBDO enables a unique combination of material properties for both improved processability and downstream reliability performance, which are unable to be achieved with current state of the technology monomers and epoxy formulation strategies.

This invention provides a method of making an electrical assembly including providing an electronic component and a substrate, wherein one of the electronic component and the substrate has a plurality of solder bumps and the other has a plurality of electrical bonding pads, electrically connecting the electronic component and the substrate, forming an underfill composition between the electronic component and the substrate, and curing the underfill composition, wherein the underfill composition includes a divinylarene diepoxide. The use of the divinylarene dioxide, such as divinylbenzene dioxide, resin enables high filler loading, high Tg values, and very low to no total chloride contamination imparted by the resin. In addition, the divinylarene dioxide resin enables a number of different hardeners to be used, unlike conventional low viscosity cycloaliphatic epoxy resins. The presence of the cured underfill between the electronic component and the substrate reinforces the solder joints and helps reduce solder joint failures during thermal cycling.

Also provided is an electronic assembly including an electronic component electrically connected to a substrate with an underfill composition between the electronic component and the substrate, wherein the underfill composition includes a reaction product of a divinylarene diepoxide.

In another embodiment, the present invention provides an underfill composition including a divinylarene diepoxide, a curing agent, and a filler, wherein the composition has a viscosity of 0.005 to 100 Pa-s at 25 °C when the filler is present in an amount of 1 to 70 vol%, based on the total volume of the composition.

Another embodiment of the present invention is directed to a process for preparing the above epoxy resin formulation.

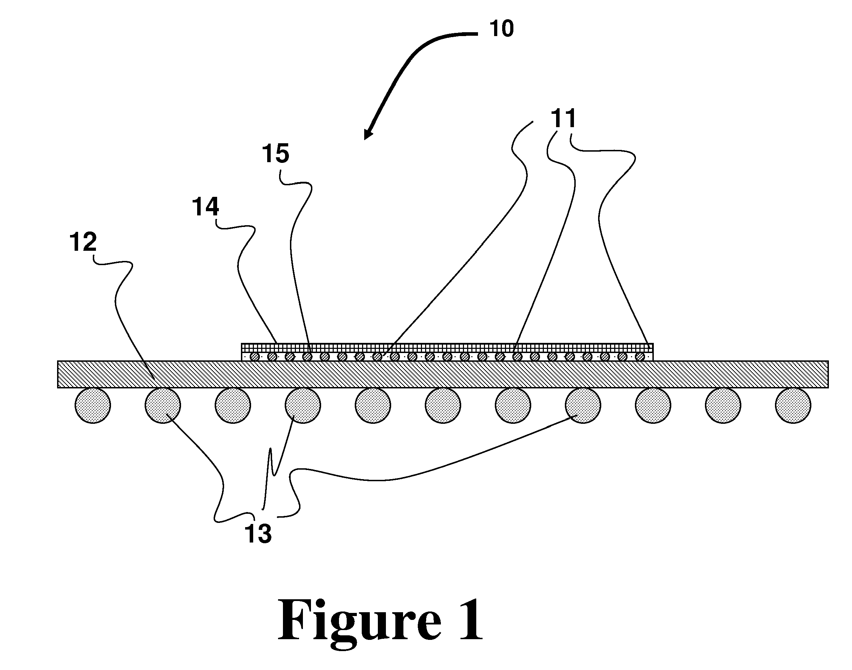

Figure 1 shows a cross section of an electronic assembly of the present invention, such as a flip chip package.

As used throughout this specification, the following abbreviations shall have the following meanings, unless the context clearly indicates otherwise: psi = pounds per square inch; °C = degrees Centigrade; g/mol = grams per mole; ppm = parts per million; rpm = revolutions per minute; Pa-s = Pascal-second; MPa = megaPascals; GPa = gigaPascal; W/mK = Watt per meter Kelvin; CTE = coefficient of thermal expansion; wt% = weight percent; vol% = volume percent; g = grams; mg = milligrams; and µm = micron = micrometer. All amounts are percent by weight and all ratios are molar ratios, unless otherwise noted. All numerical ranges are inclusive and combinable in any order, except where it is clear that such numerical ranges are constrained to add up to 100%. As used herein, the ranges include the endpoints. The terms "dioxide" and "diepoxide" are used interchangeably.

Electrical assemblies may be prepared according to the present method including the steps of: providing an electronic component and a substrate, wherein one of the electronic component and the substrate has a plurality of solder bumps and the other has a plurality of electrical bonding pads; electrically connecting the electronic component and the substrate; forming an underfill composition between the electronic component and the substrate; and curing the underfill composition, wherein the underfill composition includes a divinylarene diepoxide.

The present method may be used to attach a variety of electronic components to a variety of substrates. Suitable electronic components include, but are not limited to, dies, capacitors, resistors and the like. The term "die" refers to a workpiece that is transformed by various processes into a desired integrated circuit device. Dies are usually singulated from a wafer which may be made of a semiconducting material, a non-semiconducting material, or combinations thereof. Suitable substrates include, without limitation, printed circuit boards and flexible circuits. Electrical assemblies prepared by the present invention also include a package bonded to a substrate. A "package" refers to an integrated circuit placed on a thin circuit board and encapsulated. The package typically contains solder balls on the bottom of the board to allow connection to the substrate.

One of the electronic component and the substrate has a plurality of solder bumps and the other has a plurality of electrical bonding pads. As used herein, the term "solder bumps" includes solder bumps, solder balls, pins and pillars such as copper pillars. Solder bumps include ball grid arrays and pin grid arrays. Solder bumps may be composed of any suitable solderable material, such as, but not limited to, tin, tin-lead, tin-bismuth, tin-silver, tin-silver-copper, tin-indium and copper. Particularly useful solder bumps are those composed of tin, tin-lead, tin-silver and tin-silver-copper. The tin-alloy solder bumps are typically eutectic mixtures. For example, a suitable tin-silver solder bump has the composition of 96.5% tin and 3.5% silver. Solder bumps may be deposited by any conventional means, such as a paste or by electroplating. Solder bumps composed of alloys may be deposited directly as an alloy, such as by electroplating a Sn-Ag solder bump, or by sequentially depositing a first metal such as tin and then depositing a second metal, such as silver, on the first metal followed by reflowing the metal to form an alloy. Suitable electrical bonding pads may be any suitable pad and may be flush with the surface of the substrate or the electronic component or may be surface of the substrate of the electronic component. Suitable bonding pads may be copper, silver, gold or any other suitable metal.

In use, the solder bumps and bonding pads are fluxed to ensure good solderability. Any suitable flux may be used and is within the ability of those skilled in the art. The electronic component and the substrate are positioned such that the solder bumps and bonding pads are aligned. The assembly is then heated to reflow the solder and electrically connect (that is, solder) the electronic component and the substrate. The particular solder reflow temperature depends on the solder bump composition and is well known to those skilled in the art.

After the electronic component is soldered to the substrate, the underfill composition is flowed between the electronic component and the substrate. The underfill composition also flows around the solder joints. The underfill composition may be applied via a number of methods depending on the end application. For example, typical application methods include syringe or cartridge dispensing for underfill applications. Suitable dispensing machines are manufactured by Asymtek, A Nordson Company, or Speedline Technologies. The dispense valve design can include positive displacement, time-pressure, jet dispense, or alternate valve design with precise volume control. While generally not necessary for the present underfill compositions, a vacuum may be used to help draw the underfill composition between the electronic component and the substrate and around the solder joints.

Once the underfill composition fills the space between the electronic component and the substrate, the underfill composition is then cured. The curing of the composition may be carried out at a predetermined temperature and for a predetermined period of time sufficient to cure the composition. The particular curing conditions may be dependent on the hardeners used in the underfill composition. For example, the curing temperature may be generally from 10 °C to 200 °C; preferably from 100 °C to 190 °C; and more preferably from 125 °C to 175 °C. Suitable curing times may be from 1 minute to 4 hours, preferably from 5 minutes to 2 hours, and more preferably from 10 minutes to 1.5 hours. Below a period of time of 1 minute, the time may be too short to ensure sufficient reaction under conventional processing conditions; and above 4 hours, the time may be too long to be practical or economical.

Preferably, the present underfill composition is cured by heating the underfill composition at a first temperature of 75 to 100 °C for 2 to 90 minutes, and then heating the underfill composition at a second temperature of 125 to 200°C for 2 to 180 minutes. Preferably, the first temperature is from 80 to 95 °C, and more preferably from 80 to 90 °C. The underfill composition is preferably subjected to the first temperature for a period of 5 to 90 minutes, and more preferably from 15 to 60 minutes. The second temperature is preferably in the range of 135 to 200 °C, and more preferably from 150 to 180°C. Preferably, the underfill composition is subjected to the second temperature for a period of 10 to 150 minutes, more preferably from 20 to 150 minutes, and still more preferably from 30 to 120 minutes.

With reference to Figure 1, there is shown a cross section of an electronic assembly, such as a flip chip package, generally indicated by numeral 10, including substrate 12 having optional solder balls 13 on a lower surface of substrate 12. In addition, the electronic assembly 10 includes an electronic component 14, such as a die, electrically connected to substrate 12 through solder joint 15 (formed from a solder bump on electronic component 14 and a bonding pad on substrate 12) having cured underfill composition 11 disposed between electronic component 14 and substrate 12, wherein cured underfill composition 11 includes a reaction product of a divinylarene diepoxide.

In its broadest scope, the present invention includes a curable epoxy resin composition or formulation for use in underfill encapsulants comprising (a) a divinylarene dioxide; (b) a hardener; and (c) optionally, a catalyst. The epoxide compositions or formulations of the present invention include as embodiments (1) polymerizable, curable compositions comprising divinylarene dioxide; (2) partially cured compositions comprising divinylarene dioxide; and (3) cured compositions comprising divinylarene dioxide resulting from (1) and (2) above. The present invention also relates to the curing (that is polymerization) of compositions containing divinylarene dioxide. In addition, some level (less than about 50%) of impurities in the divinylarene dioxide are expected and can be present with little impact on final performance.

The underfill compositions of the present invention are advantageously low-viscosity, homogeneous liquids at room temperature, such as for example, less than 5.0 Pa-s at 25 °C. Solid, particulate materials, such as fillers, may be incorporated in the underfill compositions for providing various modifications to the physical properties of the uncured or cured polymer. With or without such added solid materials, the compositions fill small gaps (for example, less than 20 µm) without the necessity of applying high pressures, vacuum assist, or heating to high temperatures, although such measures can be employed, if desired. The underfill compositions can be utilized to protect fragile electronic components, wherein the composition exhibits a low total chloride content of less than 5 ppm, and preferably less than 3 ppm. "Total" chloride content includes both bound chloride and hydrolysable chloride content.

In preparing the underfill compositions of the present invention , the divinylarene dioxide, component (a), may comprise, for example, any substituted or unsubstituted arene nucleus bearing two vinyl groups in any ring position. The arene portion of the divinylarene dioxide may comprise benzene, substituted benzenes, ring-annulated benzenes, substituted ring-annulated benzenes, homologously bonded benzenes, substituted homologously bonded benzenes, or mixtures thereof. The divinylarene portion of the divinylarene dioxide may be ortho, meta, or para isomers or any mixture thereof. Additional substituents may consist of H₂O₂-resistant groups including saturated alkyl, aryl, halogen, nitro, isocyanate, or RO-(where R may be a saturated alkyl or aryl). Ring-annulated benzenes may comprise for example naphthlalene, tetrahydronaphthalene, and the like. Homologously bonded (substituted) benzenes may comprise for example biphenyl, diphenylether, and the like.

The divinylarene dioxide used for preparing the composition of the present invention may be illustrated generally by chemical Structures I-IV as follows:

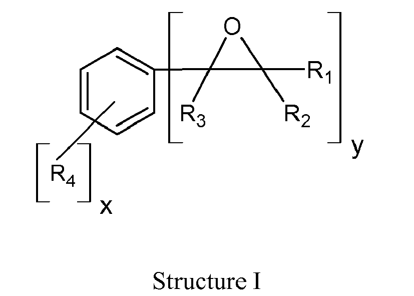

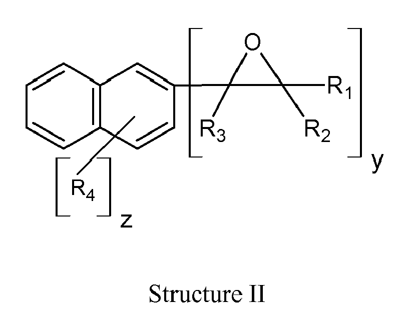

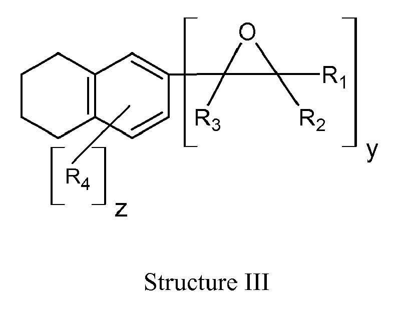

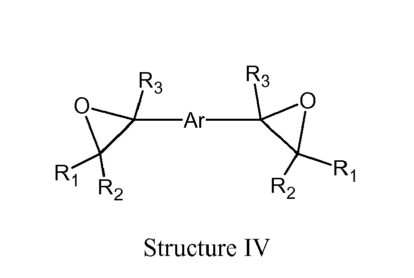

In the above Structures I, II, III, and IV of the divinylarene dioxide co-monomer of the present invention, each R₁, R₂, R₃ and R₄ individually may be hydrogen, an alkyl, cycloalkyl, an aryl or an arylalkyl group; or a H₂O₂-resistant group, including for example a halogen, a nitro, an isocyanate, or an RO group, wherein R may be an alkyl, aryl or arylalkyl; x is an integer of 0 to 4; y is an integer greater than or equal to 2; x+y is an integer less than or equal to 6; z is an interger of 0 to 6; and z+y is an integer less than or equal to 8; and Ar is an arene fragment including, for example, 1,3-phenylene group. In addition, R₄ can be a reactive group(s) including epoxide, isocyanate, or any reactive group and Z is an integer from 0 to 6 depending on the substitution pattern.

In one embodiment, the divinylarene dioxide used in the present invention may be produced, for example, by the process described in International Patent Application WO 2010/077483, incorporated herein by reference. The divinylarene dioxide compositions that are useful in the present invention are also disclosed in, for example, U.S. Patent No. 2,924,580, incorporated herein by reference.

In another embodiment, the divinylarene dioxide useful in the present invention may comprise, for example, divinylbenzene dioxide, divinylnaphthalene dioxide, divinylbiphenyl dioxide, or divinyldiphenylether dioxide, and mixtures thereof.

In a preferred embodiment of the present invention, the divinylarene dioxide used in the underfill composition includes divinylbenzene dioxide (DVBDO). Most preferably, the divinylarene dioxide component is a divinylbenzene dioxide as illustrated by the following chemical formula of Structure V:

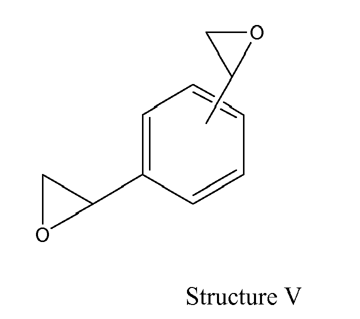

The chemical formula of the above DVBDO compound is C₁₀H₁₀O₂; the molecular weight of the DVBDO is 162.2; and the elemental analysis of the DVBDO is: C, 74.06; H, 6.21; and O, 19.73 with an epoxide equivalent weight of 81 g/mol.

Structure VI below illustrates an embodiment of a preferred chemical structure of the DVBDO useful in the present invention:

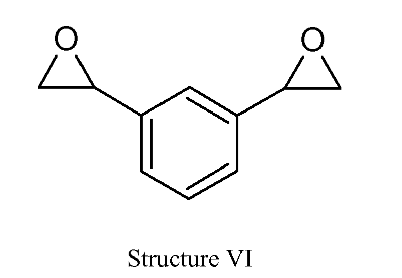

Structure VII below illustrates another embodiment of a preferred chemical structure of the DVBDO useful in the present invention:

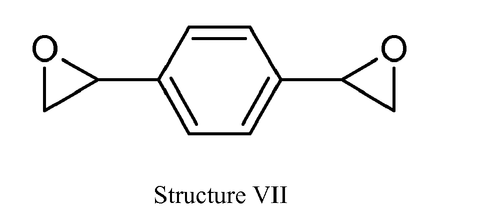

When DVBDO is prepared by the processes known in the art, it is possible to obtain one of three possible isomers: *ortho, meta,* and *para.* Accordingly, the present invention includes a DVBDO illustrated by any one of the above Structures individually or as a mixture thereof. Structures VI and VII above show the *meta* (1,3-DVBDO) and *para* isomers of DVBDO, respectively. The *ortho* isomer is rare; and usually DVBDO is mostly produced generally in a range of from 9:1 to 1:9 ratio *of meta* (Structure VI) to *para* (Structure VII) isomers. The present invention preferably includes as one embodiment a range of from 6:1 to 1:6 ratio of Structure VI to Structure VII, and in other embodiments the ratio of Structure VI to Structure VII may be from 4:1 to 1:4 or from 2:1 to 1:2.

In yet another embodiment of the present invention, the divinylarene dioxide may contain quantities (such as for example less than 20 wt%) of substituted arenes. The amount and structure of the substituted arenes depend on the process used in the preparation of the divinylarene precursor to the divinylarene dioxide. For example, divinylbenzene prepared by the dehydrogenation of diethylbenzene (DEB) may contain quantities of ethylvinylbenzene (EVB) and DEB. Upon reaction with hydrogen peroxide, EVB produces ethylvinylbenzene monoxide while DEB remains unchanged. The presence of these compounds can increase the epoxide equivalent weight of the divinylarene dioxide to a value greater than that of the pure compound but can be utilized at levels of 0 to 99 % of the epoxy resin portion.

In one embodiment, the divinylarene dioxide useful in the present invention comprises, for example, divinylbenzene dioxide (DVBDO), a low viscosity liquid epoxy resin. The viscosity of the divinylarene dioxide used in the process of the present invention ranges generally from 0.001 Pa-s to 0.1 Pa-s, preferably from 0.01 Pa-s to 0.05 Pa-s, and more preferably from 0.01 Pa-s to 0.025 Pa-s, at 25 °C.

The concentration of the divinylarene oxide used in the present invention as the epoxy resin portion of the formulation may depend on the fractions of the other formulation ingredients, however, in general the epoxy resin portion ranges from 0.5 wt% to 100 wt%, preferably, from 1 wt% to 99 wt%, more preferably from 2 wt% to 98 wt%, and even more preferably from 5 wt% to 95 wt%. For example, the concentration of DVBDO in the formulation will depend on other formulation ingredients, however in general, the concentration of the DVBDO is from 1 wt% to 99 wt%, preferably from 5 wt% to 90 wt%, and most preferably from 7 wt% to 60 wt% based on the weight of the total composition. In one embodiment of the system of the present invention, DVBDO is the epoxy resin component and the DVBDO is used in a concentration of from 20 wt% to 80 wt% based on the weight of the total composition.

In the broadest terms of the present invention, a hardener (curing agent or crosslinker) or curing agent blend (mixture of hardeners) is used in the underfill composition of the present invention. Generally, any hardener known in the art which is appropriate for curing (polymerizing) epoxy resins may be used. The hardener of choice may depend on the application requirements. The hardener useful in the present underfill composition may include, but is not limited to, dicyandiamide, substituted guanidines, phenolic, amino, benzoxazine, anhydrides, amido amines, polyamides, polyamines, aromatic amines, polyesters, polyisocyanates, polymercaptans, urea formaldehyde and melamine formaldehyde resins, and mixtures thereof. In one embodiment, the present underfill compositions are substantially free of anhydrides, and are preferably free of anhydrides.

The concentration of the hardener but will depend on stoichiometric considerations (molar ratio). A typical molar ratio of epoxy to hardener is 0.25 to 4, more preferably, 0.5 to 2, and most preferably 0.9 to 1.1.

In the broadest terms of the present invention, a catalyst may optionally be used in the present underfill compositions. Generally, any homogeneous or heterogeneous catalyst known in the art which is appropriate for facilitating the reaction between an epoxy resin and a hardener may be used. The catalyst may include, but is not limited to, imidazoles, tertiary amines, phosphonium complexes, Lewis acids, or Lewis bases, transition metal catalysts, and mixtures thereof. In one embodiment, the underfill compositions are substantially free of Lewis acid catalysts and are preferably free of Lewis acid catalysts.

The catalyst useful in the present invention may include for example a Lewis acid such as boron triflouride complexes, Lewis bases such as tertiary amines like diazabicycloundecene and 2-phenylimidazole, quaternary salts such as tetrabutyphosphonium bromide and tetraethylammonium bromide, and organoantimony halides such as triphenylantimony tetraiodide and triphenylantimony dibromide; and mixtures thereof.

When present, the concentration of the catalyst is generally from 0.05 wt% to 10 wt%, preferably from 0.1 wt% to 5 wt%, and most preferably from 0.15 wt% to 1 wt% based on the total weight of the underfill composition. The catalyst level can be adjusted to allow adequate processing in the final application.

A filler may be added to the present underfill composition to improve thermomechanical properties of the cured system imparting better component reliability performance. The presence of the filler increases the modulus of the cured underfill and reduces the CTE of the adhesive (cured underfill) in order to better match the CTE of the electronic component and the substrate. For example, the formulation may include one or more optional functional or non-functional fillers such as for example, fused silica, natural silica, synthetic silica, natural aluminum oxide, synthetic aluminum oxide, hollow fillers, aluminum trihydroxide, aluminum hydroxide oxide, boron nitride, silicon carbide, mica, aluminum powder, zinc oxide, silver, graphite, aluminum nitride, mullite, gold, carbon, carbon nanotubes, graphene, glass fibers/sheets, carbon fibers, or other organic or inorganic particulate filler, either added into the formulation in their end state or formed *in-situ.* Silica, whether fused, natural or synthetic, is a preferred filler. The surface of the fillers may optionally be treated to improve filler and polymer interaction. In another embodiment, the addition of silica filler to DVBDO blends used in underfill compositions may increase the fracture toughness of the final cured underfill material.

The acceptable particle size of the filler material generally may range from nano to conventional micro size. For example, the particle size of the filler may be in the range of from 0.0005 µm to 500 µm, preferably from 0.100 µm to 100 µm, and more preferably from 0.01 µm to 30 µm.

Acceptable filler morphologies include, but are not limited to, platelet, fibrous, spherical, needle, amorphous or any combination thereof. Fillers with different size and different shape may be combined to have a synergistic effect on coefficient of thermal expansion , modulus, electrical and / or heat conductivity.

The fillers utilized in the present invention may optionally be surface treated either before incorporation into the underfill composition, or *in-situ,* during the compounding of the formulation. Examples of surface treatments include fatty acids, silane coupling agents, titanates, zirconates or silazane compounds.

Filler loadings useful in the present invention may vary. The concentration of the filler is generally from 0 wt% to 99 wt%, preferably from 0.1 wt% to 95 wt%, more preferably from 10 wt% to 90 wt%, and most preferably from 50 wt% to 80 wt% based on the weight of the solids in the composition. Volumetric loadings can range from 0 to 90 vol%, more preferably from 0.1 to 90 vol%, still more preferably up to 85 vol%, yet more preferably from 0.1 to 85 vol%, still more preferably from 1 to 85 vol% and most preferably from 1 to 70 vol%, depending on the desired properties.

It is well-known that the high filler loadings required in conventional epoxy-based underfill compositions provide many technical challenges, such as greatly increasing the viscosity of the underfill compositions, reducing the flowability of the compositions between the electronic component and the substrate, and requiring higher application temperatures. The ever shrinking pitch size of solder bumps and bonding pads compounds this difficulty. It has been found that the present underfill compositions exhibit low viscosity and excellent flowability even with relatively high filler loadings. Specifically, the present invention provides a composition including a divinylarene diepoxide, a curing agent, and a filler, wherein the composition has a viscosity of from 0.005 to 100 Pa-s at 25 °C when the filler is present in an amount of 1 to 70 vol%, based on the total volume of the composition. Preferably, the composition has a viscosity of from 0.01 to 25 Pa-s at 25 °C, and more preferably from 0.01 to 10 Pa-s at 25 °C, when the filler is present in an amount of 1 to 70 vol%. In a particularly preferred embodiment, the composition has a viscosity of from 0.005 to 1 Pa-s at 25 °C when the filler is present in an amount of 50 to 70 vol%. It is preferred that in such composition the divinylarene diepoxide is divinylbenzene dioxide. A further advantage of the present underfill composition sis that they can be applied at or near room temperature, which is significantly lower than conventional underfill compositions.

The underfill compositions of the present invention advantageously may use a wide array of hardeners and the composition allows more choices of fillers, such as nano fillers than conventional underfill compositions, thus the formulation options of the present compositions are broadened. The present underfill compositions also have low (for example, less than 5 ppm) to no total halides. In addition, because the present underfill compositions also allow high filler loading, the underfill compositions can achieve lower CTE (for example less than 30 ppm/°C below the Tg) or better thermal conductivity (for example, greater than 1.0 W/mK) at the same flow rate during application or better flow rate at same CTE or heat conductivity.

Other optional components that may be useful in the present underfill compositions are components normally used in resin formulations known to those skilled in the art. For example, the optional components may comprise compounds that can be added to the composition to enhance application properties (for example, surface tension modifiers or flow aids), reliability properties (for example, adhesion promoters) the reaction rate, the selectivity of the reaction, and/or the catalyst lifetime.

An assortment of additives may be added to the compositions of the present invention including for example, other resins such as epoxy resins that are different from the divinylarene dioxide, component (a), diluents, stabilizers, fillers, plasticizers, catalyst deactivators, toughening agents, and the like; and mixtures thereof.

Other additives useful in the formulation of the present invention include for example, a halogen containing or halogen-free flame retardant; a synergist to improve the performance of the flame extinguishing ability such magnesium hydroxide, zinc borate, or metalocenes; a solvent for processability including for example acetone, methyl ethyl ketone, a Dowanol PMA; adhesion promoters such as modified organosilanes (epoxidized, methacryl, amino), acytlacetonates, or sulfur containing molecules; wetting and dispersing aids such as modified organosilanes, Byk 900 series and Byk W-9010, modified fluorocarbons; air release additives such as Byk-A 530, Byk-A 525, Byk-A 555, Byk-A 560; surface modifiers such as slip and gloss additives (a number of which are available from Byk-Chemie); a reactive or nonreactive thermoplastic resin such as polyphenylsulfones, polysulfones, polyethersolufones, polyvinylidene fluoride, polyetherimide, polypthalimide, polybenzimidiazole, acyrlics, phenoxy, urethane; a mold release agent such as waxes; other functional additives or prereacted products to improve polymer properties such as isocyanates, isocyanurates, cyanate esters, allyl containing molecules or other ethylenically unsaturated compounds, and acrylates; and mixtures thereof.

The concentration of the optional additives used in the present invention may range generally from 0 wt% to 99 wt%, preferably from 0.001 wt% to 95 wt%, more preferably from 0.01 wt% to 60 wt%, and most preferably from 0.05 wt% to 50 wt%.

As a general illustration of a formulation intended for use as an underfill composition in accordance with the present invention, the underfill formulation may contain the following ingredients in their respective amounts:

| | |
|---|---|
| DVBDO (The Dow Chemical Company) | 20-30 wt% |
| Kyahard AA pt (Nippon Kayaku) | 10-20 wt% |
| Denka FB-1SDX Silica (Denka Corporation) | 45-75 wt% |
| Byk W-9010 (Byk Chemie) | 0.5 wt% |
| Silwet 7608 (GE Silicones) | 0.5 wt% |
| Byk A-530 (Byk-Chemie) | 0.5 wt% |
| Silane Z-6040 (Dow Coming) | 0.7 wt% |

The process for preparing a low viscosity (for example, less than 3.0 Pa-s at 25 °C, low total chloride containing (for example, less than 5 ppm) epoxy resin formulation useful for the manufacture of semiconductor packaging materials includes blending (a) a divinylbenzene dioxide; (b) a hardener; (c) optionally, a catalyst; and (d) optionally, other ingredients as needed. For example, the preparation of the curable epoxy resin formulation of the present invention is achieved by blending with or without vacuum in a Ross PD Mixer (Charles Ross), the divinylbenzene dioxide, a curing agent, a catalyst, and optionally any other desirable additives. Any of the above-mentioned optional assorted formulation additives, for example fillers, may also be added to the composition during the mixing or prior to the mixing to form the composition.

All the components of the epoxy resin formulation are typically mixed and dispersed at a temperature enabling the preparation of an effective epoxy resin composition having a low viscosity for the desired application. The temperature during the mixing of all components may be generally from 20 °C to 80 °C and preferably from 25 °C to 35 °C. Lower mixing temperatures help to minimize reaction of the resin and hardener components to maximize the pot life of the formulation.

The blended compound is typically stored at sub-ambient temperatures to maximize shelf life. Acceptable temperature ranges are for example from -100 °C to 25 °C, more preferably, from -70 °C to 10 °C, and even more preferably at from -50 °C to 0 °C. As an illustration of one embodiment, the temperature may be -40 °C.

The divinylbenzene dioxide (DVBDO), the epoxy resin of the present invention, may be used as the sole resin to form the epoxy matrix in the final formulation; or the divinylbenzene dioxide resin may be used as one of the components in the final formulation. For example the epoxy resin may be used as an additive diluent. The use of divinylbenzene dioxide imparts improved properties to the curable composition and the final cured product over conventional glycidyl ether, glycidyl ester or glycidyl amine epoxy resins. Specifically, the use of DVBDO allows for relatively high filler loading while maintaining a relatively low viscosity at 25 °C.

In addition, the use of divinylbenzene dioxide provides a desirable low to no total halogen content to maintain the reliability of an electronic assembly's performance in high humidity testing and field use over the lifetime of the device. The halogen content, such as chlorine content, is generally less than 500 ppm; preferably less than 100 ppm, and more preferably less than 5 ppm.

The cured underfill composition (that is, the cross-linked product made from the curable composition) of the present invention shows several improved properties over cured conventional, epoxy-based underfills. For example, the cured underfill of the present invention may have a glass transition temperature (Tg) of from -55 °C to 300 °C. Generally, the Tg of the resin is higher than -60 °C, preferably higher than 0 °C, more preferably higher than 10 °C, more preferably higher than 25 °C, and most preferably higher than 50 °C. Below -55 °C, the technology described in this application does not provide any further significant advantage versus the conventional technology described in the prior art; and above 200 °C, the technology described in the present application generally would lead to a very brittle network without the inclusion of toughening technologies which is not suitable for the applications within the scope of the present application and could also cause significant warpage of the device at low temperatures (for example, less than 0 °C). Preferably, the cured underfill composition of the present invention exhibits a glass transition temperature of from 25 to 300 °C, more preferably from 50 to 250 °C and most preferably from 50 to 225 °C via ASTM D 3418.

Due to the elimination of epichlorohydrin during the epoxidation of the vinyl groups, there is little to no hydrolyzable or total chlorides present in the resin. Therefore, the present underfill composition exhibits a hydrolyzable chloride content via ion chromatography after Parr bomb extraction of approximately 60 mesh particles at 120 °C for 24 hours of from 0.00001 and 5000 ppm, preferably from 0.00001 and 100 ppm and most preferably less than 5 ppm.

The structures below show the various products and by-products formed in the reaction of conventional glycidyl ether resins leading to higher levels of total and hyrolyzable chloride content:

| | | |
|---|---|---|
| 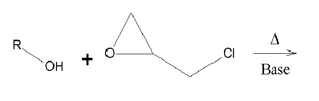 | 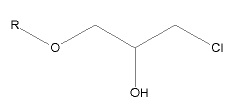 | (1) Hydrolyzable chloride |
| | | |
| | | Undesired byproduct due to incomplete ring closure |
| | 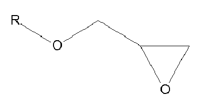 | (2) Desired product |
| | | |
| | 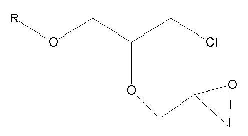 | (3) Bound chloride |
| | | |
| | | Undesired byproduct due to incomplete ring closure + 1 epi adding to secondary hydroxyl |

The cured underfill composition of the present invention exhibits a fracture toughness measured by ASTM D 5045 (at room temperature) value higher than 1.0 MPa.m^{1/2}, preferably higher than 1.7 MPa.m^{1/2}, and more preferably higher than 2.0 MPa.m^{1/2} (megaPascals per meter).

The cured underfill composition of the present invention exhibits a flexural modulus below the Tg of higher than 1 GPa, preferably higher than 2 GPa and more preferably between 3.5 MPa and 15 GPa via ASTM D 790.

The cured underfill of the present invention exhibits a CTE below the Tg of 65 ppm/°C, and preferably lower than 50 ppm/°C via ASTM D 5335.

The underfill compositions of the present invention exhibit a weight loss during cure of less than 10 percent via thermogravimetric analysis according to ASTM E 1131.

In one embodiment, the epoxy resin formulations of the present invention, utilizing the diepoxide derivative of divinylarene, may be used as capillary underfill encapsulant for semiconductor packaging materials. The use of the epoxy resin formulation enables relatively high filler loading (for example, 30% by volume, such as from 30 to 85 vol%), high Tg values after cure (for example, 90 °C), and very low to no total chloride contamination for example, <5 ppm) imparted by the resin. In addition, this resin enables a number of different hardeners to be used, unlike conventional low viscosity cycloaliphatic epoxy resins. The comparatively low chloride contamination results from the synthetic route to manufacture the molecule which does not utilize halogenated intermediates, for example epichlorohydrin.

### EXAMPLES

The following examples and comparative examples further illustrate the present invention in detail but are not to be construed to limit the scope thereof.

### Example 1-3 and Comparative Examples A and B

A set of experiments was constructed to explore the impact of filler loading and resin on key properties of interest. Comparative Examples A and B and Examples 1 through 3 were prepared according to the following procedure:
The ingredients of each composition were placed into a lidded 75 milliter (mL) polypropylene plastic jar and blended at 3200 revolutions per minute (rpm) for 120 seconds using a SpeedMixer ® DAC 150 distributed by FlackTek. The filler loading levels were 35 %, 50 %, and 65 % by weight on solids. The experimental design also included resin type as a variable utilizing D.E.R. ^{TM} 354 (a bisphenol F based epoxy resin with an average epoxy equivalent weight (EEW) of 174 g/mol, and commercially available from The Dow Chemical Company; and divinylbenzene dioxide (DVBDO). A center point was included which combined the two resins at a 1:1 weight ratio while maintaining a 1:1 stoichiometric balance with an aromatic amine hardener, dethyltoluenediamine (DETDA).

Other raw materials used in these examples are described as follows: Ethacure 100 is DETDA commercially available from Albemarle Corporation; Byk-A 530 is a polysiloxane defoaming aid produced by Byk-Chemie, GmbH, Germany; Byk W996 is a wetting aid that is a copolymer with acidic groups (acid value of 71 mg KOH/g) produced by Byk-Chemie, GmbH, Germany; Silane Z-6040 is a epoxy functional silane coupling agent produced by Dow-Corning; Modaflow is a surface tension modifier / flow aid produced by Ctyec Surface Specialties; and Denka FB-1SDX is a fused, synthetic spherical silica powder with a mean particle size of about 1.5 microns produced by Denka Co JP, Japan. Coat O Sil 2810 is an epoxy terminated polydimethylsiloxane from Momentive. Jeffamine ® D230 is a polyetheramine from Hunstman Corporation. Amicure PACM is a cycloaliphatic amine from Air Products®. MP15EF and MP8FS are silica fillers available from Tatsumori. Regal 400 R is a grade of carbon black from Cabot Corporation. Silwet L-7608 is an organosilicone surface tension modifier from Momentive Performance Materials.

**Table I - Formulations**

| | Comparative Example A | Comparative Example B | Example 1 | Example 2 | Example 3 |
|---|---|---|---|---|---|
| D.E.R. 354 | 0.5074 | 0.2677 | 0.1735 | 0.0000 | 0.0000 |
| DVBDO | 0.0000 | 0.0000 | 0.1735 | 0.4115 | 0.2171 |
| DETDA (Ethacure 100) | 0.1276 | 0.0673 | 0.1379 | 0.2235 | 0.1179 |
| Byk-A 530 | 0.0025 | 0.0025 | 0.0025 | 0.0025 | 0.0025 |
| Byk W996 | 0.0025 | 0.0025 | 0.0025 | 0.0025 | 0.0025 |
| Silane Z-6040 | 0.0070 | 0.0070 | 0.0070 | 0.0070 | 0.0070 |
| Modaflow | 0.0030 | 0.0030 | 0.0030 | 0.0030 | 0.0030 |
| Denka FB-1SDX | 0.3500 | 0.6500 | 0.5000 | 0.3500 | 0.6500 |
| | 1.0000 | 1.0000 | 1.0000 | 1.0000 | 1.0000 |
| Moles of Epoxy / 100 g | 0.2900 | 0.1530 | 0.3134 | 0.5080 | 0.2680 |
| Moles of Hardener / 100 g | 0.2900 | 0.1530 | 0.3134 | 0.5080 | 0.2680 |
| Ratio | 1.0000 | 1.0000 | 1.0000 | 1.0000 | 1.0000 |
| *Weigh Up* | | | | | |
| D.E.R. 354 | 10.15 | 5.35 | 3.47 | 0.00 | 0.00 |
| DVBDO | 0.00 | 0.00 | 3.47 | 8.23 | 4.34 |
| DETDA (Ethacure 100) | 2.55 | 1.35 | 2.76 | 4.47 | 2.36 |
| Byk A530 | 0.05 | 0.05 | 0.05 | 0.05 | 0.05 |
| Byk W996 | 0.05 | 0.05 | 0.05 | 0.05 | 0.05 |
| Silane Z-6040 | 0.14 | 0.14 | 0.14 | 0.14 | 0.14 |
| Modaflow | 0.06 | 0.06 | 0.06 | 0.06 | 0.06 |
| Denka FB-1SDX | 7.00 | 13.00 | 10.00 | 7.00 | 13.00 |
| | 20.00 | 20.00 | 20.00 | 20.00 | 20.00 |

After blending in the Speedmixer and degassing in a vacuum oven for 15 minutes at about 3000 Pa, 8 grams (g) of each sample were placed into separate aluminum weighing pans. The pans were placed into an oven at 150 °C for 60 minutes and then into a 175 °C oven for 90 minutes. After cooling the samples (slugs) were removed from the aluminum pan and cut using a Buehler Isomet 1000 saw. A small sample, approximately 3 mm x 3 mm was cut from each slug and analyzed via thermomechanical analysis (TMA) utilizing a TA Instruments Q400 thermomechanical analyzer fitted with a 3 mm probe. The analysis procedure consisted of one element; ramp at 10 °C/minute from room temperature (about 25 °C) to 275 °C with a nitrogen purge of 50 mL/minute at a force of 0.05 N. Universal Analysis data analysis software (commercially available from TA Instruments) was then utilized to determine the glass transition temperature (Tg) (onset) and the CTE below the Tg (α1 CTE) for the sample analyzed.

Viscosity versus temperature of the blended samples was measured using a TA Instruments ARES Analyzer (TA Instruments) fitted with a 35 mm upper plate and a 50 mm lower plate. The test procedure consisted of a dynamic temperature ramp from 25 °C to 250 °C at 5 °C/minute ramp rate.

Table II below contains a summary of the data collected on model underfill formulations. Of note is the combination of high Tg and low viscosity. The Tg via TMA of the DVBDO based samples are about 70 °C higher than those made with D.E.R. ^{TM} 354. In addition the minimum viscosity of the DVBDO sample at 65 % filler loading is 20 % of the sample made with D.E.R. 354. Of note also is the relatively low Tg of the D.E.R. 354 system without the use of any catalyst.

**Table II - Properties**

| | Comparative Example A | Comparative Example B | Example 1 | Example 2 | Example 3 |
|---|---|---|---|---|---|
| Filler Loading, % (fused silica, D50=1µm) | 35 | 65 | 50 | 35 | 65 |
| Resin Package (D.E.R. 354 = Bisphenol-F epoxy) | D.E.R. 354 | D.E.R. 354 | 50:50 (D.E.R. 354: DVBDO) | DVBDO | DVBDO |
| Minimum Viscosity, Pa-s (ARES, 5°C/minute ramp) | 0.0461 | 0.4139 | 0.0316 | 0.0129 | 0.0863 |
| Minimum Viscosity, °C (ARES, 5 °C/minute ramp) | 128 | 119 | 128 | 105 | 108 |
| Tg, °C (TMA, 10 °C/minute ramp) | 113 | 112 | 151 | 186 | 189 |
| α1 CTE, ppm/°C (TMA, 10 °C/minute ramp) | 64 | 38 | 52 | 50 | 32 |

### Examples 4 - 10

Examples 4 through 10 were carried out using the same procedure as described in Examples 1-3; and included the following raw materials: DVBDO, a dioxide, available from The Dow Chemical Company; Ancamide ® 506, a polyamide hardener, commercially available from Air Products; Jeffamine ® D230, a polyetheramine, commercially available from Huntsman Corporation; Silazane Z-6079 (hexamethyldisilazane) commercially available from Dow Coming; MP-15EF - Silica filler commercially available from Tatsumori Ltd, Japan; and Silane Z-6040, an epoxy silane, commercially available from Dow Coming.

The formulations of Examples 4 through 10, described in Table III, were blended utilizing a SpeedMixer® DAC150 (FlackTek, Landrum, SC) according to the following procedure:
Add DVBDO and MP 15EF to a 75 mL lidded polypropylene jar. Mix at 3500 rpm for 50 seconds. Add Silane Z-6079 and mix at 3500 rpm for 120 seconds. Add hardeners and Silane 6040 and mix at 3500 rpm for 60 seconds. Then place in a vacuum oven at 25 °C at about 3000 Pa for 15 minutes to degas the samples.

**Table III - Formulations**

| | Example 4 | Example 5 | Example 6 | Example 7 | Example 8 | Example 9 | Example 10 |
|---|---|---|---|---|---|---|---|
| DVBDO | 0.2596 | 0.2574 | 0.1683 | 0.2021 | 0.1501 | 0.1427 | 0.2183 |
| Ancamide 506 | 0.0000 | 0.0000 | 0.0000 | 0.0505 | 0.0817 | 0.1058 | 0.1618 |
| Jeffamine D230 | 0.1070 | 0.1354 | 0.0885 | 0.0505 | 0.0000 | 0.0000 | 0.0000 |
| Amicure PACM | 0.0713 | 0.0451 | 0.0295 | 0.0590 | 0.0545 | 0.0378 | 0.0578 |
| Silane Z-6079 | 0.0061 | 0.0061 | 0.0077 | 0.0069 | 0.0077 | 0.0077 | 0.0061 |
| MP 15 EF Silica | 0.5500 | 0.5500 | 0.7000 | 0.6250 | 0.7000 | 0.7000 | 0.5500 |
| Silane Z-6040 | 0.0060 | 0.0060 | 0.0060 | 0.0060 | 0.0060 | 0.0060 | 0.0060 |
| Total | 1.0000 | 1.0000 | 1.0000 | 1.0000 | 1.0000 | 1.0000 | 1.0000 |
| Moles of Epoxy / 100 g | 0.3205 | 0.3178 | 0.2078 | 0.2495 | 0.1853 | 0.1762 | 0.2695 |
| Moles of Hardener / 100 g | 0.3142 | 0.3116 | 0.2037 | 0.2446 | 0.1816 | 0.1727 | 0.2642 |
| Ratio | 1.0200 | 1.0200 | 1.0200 | 1.0200 | 1.0200 | 1.0200 | 1.0200 |
| DVBDO | 3.89 | 3.86 | 2.52 | 3.03 | 2.25 | 2.14 | 3.27 |
| Ancamide 506 | 0.00 | 0.00 | 0.00 | 0.76 | 1.23 | 1.59 | 2.43 |
| Jeffamine D230 | 1.61 | 2.03 | 1.33 | 0.76 | 0.00 | 0.00 | 0.00 |
| Amicure PACM | 1.07 | 0.68 | 0.44 | 0.88 | 0.82 | 0.57 | 0.87 |
| Silane Z-6079 | 0.09 | 0.09 | 0.12 | 0.10 | 0.12 | 0.12 | 0.09 |
| MP 15 EF | 8.25 | 8.25 | 10.50 | 9.38 | 10.50 | 10.50 | 8.25 |
| Silane Z-6040 | 0.09 | 0.09 | 0.09 | 0.09 | 0.09 | 0.09 | 0.09 |
| Total | 15.00 | 15.00 | 15.00 | 15.00 | 15.00 | 15.00 | 15.00 |

After the final mix step, samples of the formulations were analyzed using a TA Instruments AR2000 rheometer. The rheometer was fitted with a 60 mm, 1 degree cone. The test procedure consisted of a pre-shear at 10 sec⁻¹ for 30 seconds followed by a 120 second hold at 10 sec⁻¹ both steps at 25 °C and data points recorded every 2 seconds. The viscosity value reported is the average of the last 10 data points.

Approximately 9 g of each sample were poured into aluminum weighing dishes and cured at 85 °C for 45 minutes followed by 45 minutes at 175 °C. The cured samples were removed from the oven and allowed to return to room temperature then placed in plastic storage bags.

A TA Instruments 2920 Dual Cell DSC was used to determine the Tg of the samples after cure. The procedure consisted of a singe ramp from 25 °C to 300 °C at a 10 °C/min ramp rate with a nitrogen purge of 50 mL/minute. The Tg was determined using the extrapolated tangents method in the TA Instruments Universal Analysis software. A small piece (approximately 15 mg) was cut from each cured sample and analyzed according to the preceding method.

In addition, a TA Instruments Q400 Thermomechanical Analyzer was used to measure the CTE of each sample. The values below (α1) and above (α2) the Tg are reported. The procedure consisted of a single temperature ramp from 25 °C to 300 °C at 5 °C/minute ramp with a nitrogen purge of 50 mL/minute. The results are described in Table IV.

**Table IV - Properties**

| | Example 4 | Example 5 | Example 6 | Example 7 | Example 8 | Example 9 | Example 10 |
|---|---|---|---|---|---|---|---|
| Viscosity, Pa-s (10 sec-1, 25 °C) | 0.081 | 0.071 | 0.252 | 0.140 | 0.455 | 0.515 | 0.180 |
| Tg After Cure, °C (DSC, 10 °C/minute ramp) | 143 | 125 | 126 | 146 | 152 | 134 | 139 |
| CTE Below Tg, ppm/°C (TMA, 5 °C/minute ramp) | 42 | 37 | 26 | 39 | 38 | 51 | 74 |
| CTE Above Tg, ppm/°C (TMA, 5 °C/minute ramp) | 102 | 98 | 63 | 93 | 78 | 81 | 112 |

## Claims

1. A method of making an electrical assembly comprising: providing an electronic component and a substrate, wherein one of the electronic component and the substrate has a plurality of solder bumps and the other has a plurality of electrical bonding pads; electrically connecting the electronic component and the substrate; forming an underfill composition between the electronic component and the substrate; and curing the underfill composition; wherein the underfill composition comprises a divinylarene diepoxide.

2. The method of claim 1, wherein the divinylarene dioxide is divinylbenzene dioxide.

3. The method of claim 1 wherein the underfill composition further comprises a curing agent.

4. The method of claim 1 wherein the underfill composition further comprises a filler in an amount of up to 85 vol%.

5. The method of claim 4 wherein the filler is present in an amount of 50 to 70 wt% and wherein the underfill composition has a viscosity of 0.05 to 1 Pa-s at 25 °C.

6. The method of claim 1 wherein the curing step comprises: heating the underfill composition at a first temperature of 75 to 100 °C for 2 to 90 minutes, and then heating the underfill composition at a second temperature of 125 to 200°C for 2 to 180 minutes.

7. An electronic assembly comprising an electronic component electrically connected to a substrate with an underfill composition between the electronic component and the substrate, wherein the underfill composition comprises a reaction product of a divinylarene diepoxide.

8. The electronic assembly of claim 7 wherein the underfill composition further comprises a filler.

9. A composition comprising a divinylarene diepoxide, a curing agent, and a filler, wherein the composition has a viscosity of 0.005 to 100 Pa-s at 25 °C when the filler is present in an amount of 1 to 70 vol%, based on the total volume of the composition.

10. The composition of claim 9 wherein the divinylarene diepoxide is divinylbenzene dioxide.
